# EUROPÄISCHE PATENTSCHRIFT

(11) **EP 0 523 487 B1**
(45) Veröffentlichungstag und Bekanntmachung des Hinweises auf die Patenterteilung: **06.09.2000**
(21) Anmeldenummer: 92111374.2
(22) Anmeldetag: 04.07.1992
(51) Int. Cl.: H01L 29/76, H01L 29/36, H01L 21/335

(54) **Heterostruktur-Feldeffekttransistor mit pulsdotiertem Kanal**
Heterostructure field effect transistor with pulse doped channel
Transistor à effet de champ à hétérostructure avec canal dopé par impulsion

(30) Priorität: 19.07.1991 DE 4123939
(43) Veröffentlichungstag der Anmeldung: 20.01.1993
(73) Patentinhaber: DaimlerChrysler AG, 70567 Stuttgart (DE)
(72) Erfinder: Dickmann, Jürgen, Dipl.-Ing., W-7900 Ulm-Einsingen (DE)
(74) Vertreter: Fröhling, Werner Otto, Dr.

(56) Entgegenhaltungen:
- EP-A- 0 214 047
- PATENT ABSTRACTS OF JAPAN vol. 010, no. 367 (E-462)9. Dezember 1986 & JP-A-61 161 773 (MATSUSHITA ELECTRIC IND CO LTD) 22. Juli 1986
- SUPERLATTICES AND MICROSTRUCTURES Bd. 8, Nr. 3 , 1990 , LONDON, GB Seiten 341 - 344 XP203416 G. PAPAIOANNOU ET AL. 'PSEUDOMORPHIC InGaAs HEMTs ON GaAs SUBSTRATES WITH UNDOPED AND DOPED CHANNELS'
- PATENT ABSTRACTS OF JAPAN vol. 13, no. 348 (E-799)(3696) 4. August 1989 & JP-A-01 108 779 (FUJITSU) 26. April 1989
- IEEE JOURNAL OF QUANTUM ELECTRONICS Bd. QE-22, Nr. 9 , September 1986 , NEW YORK US Seiten 1845 - 1852 H. SAKAKI 'PHYSICAL LIMITS OF HETEROSTRUCTURE FIELD-EFFECT TRANSISTORS AND POSSIBILITIES OF NOVEL QUANTUM FIELD-EFFECT DEVICES'
- JAPANESE JOURNAL OF APPLIED PHYSICS Bd. 30, Nr. 2A , Februar 1991 , TOKYO JP Seiten L166 - L169 XP223143 K. MATSUMURA 'A NEW HIGH ELECTRON MOBILITY TRANSISTOR (HEMT) STRUCTURE WITH A NARROW QUANTUM WELL FORMED BY INSERTING A FEW MONOLAYERS IN THE CHANNEL'
- SOLID STATE ELECTRONICS Bd. 34, Nr. 3 , März 1991 , OXFORD GB Seiten 253 - 258 D. G. LIU ET AL. 'ANALYSIS OF SEVERAL HIGH-ELECTRON-MOBILITY-TRANSISTOR STRUCTURES BY A SELF-CONSISTENT METHOD'
- IEEE TRANSACTIONS ON ELECTRON DEVICES Bd. 37, Nr. 10 , Oktober 1990 , NEW YORK US Seiten 2171 - 2175 XP142493 P. P. RUDEN 'AlGaAs/InGaAs/GaAs QUANTUM WELL DOPED CHANNEL HETEROSTRUCTURE FIELD EFFECT TRANSISTORS'
- IEEE EDL-11,no.7, Juli 1990, Seiten 303-305

## Beschreibung

Die Erfindung betrifft einen Heterostruktur-Feldeffekttransistor nach dem Oberbegriff des Patentanspruchs 1.

Derartige Heterostruktur-Feldeffekttransistoren werden in analogen Hochfrequenzschaltungen, beispielsweise in monolithisch integrierten Sender- und Empfängermodulen oder in Leistungsverstärkern verwendet.

Aus Veröffentlichungen von Saunier et al. in IEEE Electron Device Letters, Vol. 9, No. 8, S. 397-398, 1988 und IEEE Transactions on Electron Devices, Vol. 36, No. 10, S. 2231-2234, 1989 ist der Einbau von Dotierstoff in den leitenden Kanal von Heterostruktur-Feldeffekttransistoren (HFET) als homogene Dotierung oder in Form eines breiten Dotierpulses bekannt. Durch eine derartige Dotierung verschlechtern sich jedoch die Transporteigenschaften der Elektronen im HFET-Kanal, d.h. die Beweglichkeit und die Driftgeschwindigkeit der Ladungsträger wird geringer als in einen undotierten HFET.

In EP-A 214 047 ist ein Heterostruktur-Feldeffekttransistor mit einer in der Mitte einer undotierten Kanalschicht angeordneten planar dotierten Schicht beschrieben.

Aus IEEE Electron Device Letters, Vol.12, No. 4, April 1991, S. 149/150 ist ein Heterostruktur-Feldeffekttransistor für hohe Verstärkung bei hohen Frequenzen bekannt, bei welchem innerhalb einer 15nm dicken Kanalschicht ein schmaler pulsdotierter Bereich asymmetrisch in einem Abstand von 10nm zum Heteroübergang angeordnet ist.

Aus Jap. Journal Applied Physics, Vol. 30, No. 2A, Febr. 1991, S. L166-L169 sind schließlich Heterostruktur-Feldeffekttransistoren bekannt, bei welchen in eine homogene Kanalschicht aus GaAs oder InGaAs wenige Monolagen InAs eingebaut sind. Die optimale Lage der eingebauten Monolagen befindet sich zwischen der Mitte der Kanalschicht und dem Heteroübergang der Transistorstruktur.

Aufgabe der vorliegenden Erfindung ist es, einen Heterostuktur-Feldeffekttransistor mit höherem Sättigungsstrom ohne nachteilige Beeinflussung der Hochfrequenzeigenschaften anzugeben.

Die Erfindung ist im Patentanspruch 1 beschrieben. Die Unteransprüche enthalten vorteilhafte Ausgestaltungen und Weiterbildungen der Erfindung.

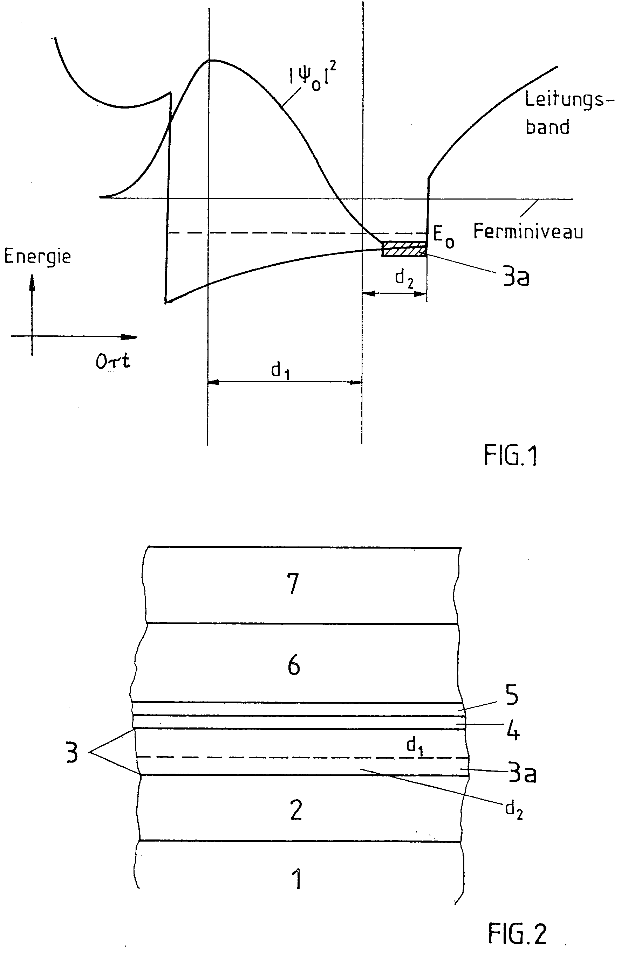

Durch den Einbau der Dotierung als sehr schmalen Puls an der den Heteroübergang des HFET gegenüberliegenden Seite der Kanalschicht wird bei positiven Gate-Spannungen der Schwerpunkt der Aufenthaltswahrscheinlichkeit |ψₒ|² der Elektronen (ψₒ Elektronen-Wellenfunktion) von dem Ort der eingebauten Dotierung räumlich getrennt (Fig. 1) Dadurch erfolgt eine Reduzierung der Coulombstreuung. Die Reduzierung der Coulombstreuung führt zu höheren Beweglichkeiten und Geschwindigkeiten der Ladungsträger im Kanal.

Der erfindungsgemäße HFET besitzt deshalb den Vorteil, daß zusätzliche Ladungsträger im Kanal zur Verfügung stehen und über die Gate-Spannung die Transporteigenschaften des Transistors derart moduliert werden, daß die Ladungsträger im dotierten Kanal Transporteigenschaften aufweisen wie im Fall des undotierten Kanals nur bei einem wesentlich höheren Sättigungsstrom.

Die Erfindung wird im folgenden anhand eines Ausführungsbeispiels näher beschrieben unter Bezugnahme auf schematische Zeichnungen.

Zur Herstellung des erfindungsgemäßen HFET wird beispielsweise gemäß Fig. 2 auf einem halbisolierenden Substrat 1, aus z.B. GaAs, eine GaAs-Pufferschicht und ein AlGaAs/GaAs-Übergitter 2 aufgebracht. Darauf wird eine z.B. 12nm dicke In_{0.2}Ga_{0.8} As-Schicht 3 aufgewachsen, in die durch einen schmalen Puls eine d₂ = 2nm dünne Dotierung aus z.B. Si eingebracht wird. Der Abstand zwischen Kanaldotierung 3a und dem aus der InGaAs-Schicht 3 und der darauf aufgewachsenen GaAs-Schicht 4 gebildeten Heteroübergang beträgt d₁ = 10nm. Die GaAs-Schicht 4 ist undotiert und besitzt eine Schichtdicke von 2nm. Darauf sind eine undotierte, 3nm-dünne Al_{0.25} Ga_{0.75} As-Schicht 5, eine 40nm-dicke Al_{0.25}Ga_{o.75}As-Schicht 6 mit einer negativen Ladungsträgerkonzentration von 3 · 10¹⁸ cm⁻³ und eine 30nm-dicke GaAs-Schicht 7 mit einer negativen Ladungsträgerkonzentration von bis zu 10¹⁹ cm⁻³ aufgewachsen. Anstelle der hochdotierten AlGaAs-Schicht 6 kann auch eine pulsdotierte AlGaAs-Schicht mit einer Pulsdotierung in einen Bereich von 10nm und 5 · 10⁻¹² Ladungsträger pro cm² mit einer Gesamtschichtdicke von 35nm aufgewachsen werden.

Mit dem erfindungsgemäßen HFET gemäß Fig. 2 werden bei einer positiver Gate-Spannung von 0.5V Sättigungsströme von etwa 720mA/mm mit einer Steilheit von 625mS/mm erreicht.

Es werden dadurch Frequenzen bis zu fₘₐₓ = 195 GHz erzielt.

Bei negativer Gate-Spannung werden trotz der zusätzlichen Kanaldotierung sehr gute Sperreigenschaften des erfindungsgemäßen Transistors erreicht.

Die Erfindung ist jedoch nicht auf die im Ausführungsbeispiel angegebenen Materialien beschränkt, sondern für alle Halbleitermaterialien geeignet, die die Herstellung eines HEMT (High Electron Mobility Transistors) ermöglichen. Die Schichtdicken-Dotierungen und die Indium-/Aluminium-Konzentrationen sind dabei aufeinander abzustimmen. Es sind z.B. auch Al_{0.3}Ga_{0.7}As/In_{0.25}Ga_{0.75}As Heterostrukturen verwendbar. Generell können Heterostrukturen aus III/V-Halbleiterverbindungen wie etwa AlGaAs/GaAs/AlGaAs, oder AlGaAs/InGaAs, oder InAlAs/InGaAs, oder InAlAs/InGaAs/InP, oder InP/InGaAs, oder InSb/AlSb oder Si/SiGe-Heterostrukturen gemäß der DE-OS 3 731 000 verwendet werden. Wesentlich ist bei den verwendeten Heterostrukturen, daß die Schichtdicke der Kanalschicht so gewählt wird, daß bei gitterverspannten Heterostrukturen die kritische Schichtdicke nicht überschritten wird, so daß keine Gitter-Relaxation auftritt und bei unverspannten Gitterstrukturen die Kanalschichtdicke möglichst groß ist. Die Pulsdotierung muß auf die dem Heteroübergang entgegengesetzten Seite des Kanals beschränkt werden.

## Patentansprüche

1. Heterostruktur-Feldeffekttransistor mit einer Halbleiterschichtenfolge aus
- einer stromführenden Kanalschicht (3), die aus einem Halbleitermaterial hoher Ladungsträgerbeweglichkeit besteht und lediglich in einem schmalen Bereich (3a) n-dotiert ist
- einer undotierten Schicht (4, 5), die mit der Kanalschicht einen Heteroübergang bildet, und
- einer n-dotierten Schicht (6) oberhalb der undotierten Schicht,
dadurch gekennzeichnet, daß der schmale dotierte Bereich der Kanalschicht pulsdotiert ist und unmittelbar an der dem genannten Heteroübergang gegenüberliegenden Seite der Kanalschicht angeordnet ist.

2. Heterostruktur-Feldeffekttransistor nach Anspruch 1, dadurch gekennzeichnet, daß das die aktiven Transistorschichten aus III/V-Halbleiterverbindungen aufgebaut sind.

3. Heterostruktur-Feldeffekttransistor nach Anspruch 1 und 2, dadurch gekennzeichnet, daß die aktiven Transistorschichten eine unverspannte Halbleiter-Gitterstruktur und eine dicke Kanalschicht besitzen.

4. Heterostruktur-Feldeffekttransistor nach Anspruch 1 und 2, dadurch gekennzeichnet, daß die aktiven Transistorschichten aus gitterfehlangepaßten Halbleiterschichten aufgebaut sind und daß die Kanalschicht eine unterkritische Schichtdicke besitzt.

5. Heterostruktur-Feldeffekttransistor nach Anspruch 2, dadurch gekennzeichnet,
- daß die Kanalschicht aus In_{y}Ga_{1-y} As mit einer Schichtdicke von 12nm besteht und
- daß die In_{0.8} Ga_{0.8} As-Schicht einen pulsdotierten Bereich von d₂ = 2nm in einem Abstand d₁ = 10nm vom Heteroübergang enthält mit einer Si-Dotierung von 1 x 10¹²cm⁻².

6. Heterostruktur-Feldeffekttransistor nach Anspruch 2, dadurch gekennzeichnet, daß der Transistor aus einer Si/SiGe-Schichtenfolge aufgebaut ist, die eine pulsdotierte SiGe-Kanalschicht mit unterkritischer Schichtdicke enthält.

## Claims

1. Heterostructure field effect transistor with a semiconductor layer sequence consisting of
- a current-conducting channel layer (3), which consists of a semiconductor material of higher charge carrier mobility and is n-doped merely in a narrow region (3a),
- an undoped layer (4, 5), which forms a heterotransition with the channel layer, and
- an n-doped layer (6) above the undoped layer,
characterised in that the narrow, doped region of the channel layer is pulse-doped and is arranged directly at the side of the channel layer opposite to the said heterotransition.

2. Heterostructure field effect transistor according to claim 1, characterised in that the active transistor layers are built up from III/V semiconductor compounds.

3. Heterostructure field effect transistor according to claim 1 and 2, characterised in that the active transistor layers have an unbraced semiconductor lattice structure and a thick channel layer.

4. Heterostructure field effect transistor according to claim 1 and 2, characterised in that the active transistor layers are built up from semiconductor layers matched to lattice disorder and that the channel layer has a subcritical layer thickness.

5. Heterostructure field effect transistor according to claim 2, characterised in that
- the channel thickness consists of In_{y}Ga_{1-y} As with a layer thickness of 12 nm and
- the In_{0.8}Ga_{0.8}AS layer contains a pulse-doped region of d₂ = 2 nm at a spacing d₁ = 10 nm from the heterostructure, with an Si doping of 1 x 10-¹²cm⁻².

6. Heterostructure field effect transistor according to claim 2, characterised in that the transistor is built up from an Si/SiGe layer sequence which contains a pulse-doped SiGe channel layer with subcritical layer thickness.

## Revendications

1. Transistor à effet de champ à hétérostructure comportant une succession de couches semiconductrices comprenant
- une couche de canal (3) véhiculant le courant et qui est constituée par un matériau semiconducteur dans lequel la mobilité des porteurs de charges est élevée, et qui est dopée du type n uniquement dans une zone étroite (3a),
- une couche non dopée (4,5), qui forme une hétérojonction avec la couche de canal, et
- une couche (6) dopée de type n située au-dessus de la couche non dopée,
caractérisé en ce que la zone étroite dopée de la couche de canal est dopée d'une manière impulsionnelle et est disposée directement sur le côté de la couche de canal, situé à l'opposé de ladite hétérojonction.

2. Transistor à effet de champ à hétérostructure selon la revendication 1, caractérisé en ce que les couches actives du transistor sont constituées par des combinaisons de semiconducteurs III/V.

3. Transistor à effet de champ à hétérostructure selon les revendications 1 et 2, caractérisé en ce que les couches actives du transistor possèdent une structure de grille semiconductrice non déformée et une couche de canal épaisse.

4. Transistor à effet de champ à hétérostructure selon les revendications 1 et 2, caractérisé en ce que les couches actives du transistor sont constituées par des couches semiconductrices adaptées du point de vue des défauts de grille et que la couche de canal possède une épaisseur sous-critique.

5. Transistor à effet de champ à hétérostructure selon la revendication 2, caractérisé en ce
- que la couche de canal est formée de In_{y}Ga_{1-y}As possédant une épaisseur de 12 nm, et
- que la couche de In_{0,8}Ga_{0,8}As possède une zone dopée par impulsions de d₂ = 2 nm à une distance d₁ = 10 nm de l'hétérojonction, avec un dopage en Si égal à 1 x 10¹² cm⁻¹.

6. Transistor à effet de champ à hétérostructure selon la revendication 2, caractérisé en ce que le transistor est constitué par une succession de couches Si/SiGe, qui contient une couche de canal en SiGe dopée de façon impulsionnelle et possédant une épaisseur sous-critique.
